# EUROPEAN PATENT APPLICATION

(11) **EP 4 797 267 A1**
(43) Date of publication of application: **26.08.2026**
(21) Application number: 25817392.1
(22) Date of filing: 27.05.2025
(51) Int. Cl.: G11C 11/409, G06F 3/06, G11C 7/18

(54) **COMMAND PROCESSING CIRCUIT, COMMAND PROCESSING METHOD, AND PIM APPARATUS**

(30) Priority: 26.09.2024 CN 202411359383
(71) Applicant: CXMT Corporation, Hefei, Anhui 230601 (CN)
(72) Inventor: SUN, Hao, Hefei, Anhui 230601 (CN); JIANG, Mingfeng, Hefei, Anhui 230601 (CN)
(74) Representative: Gulde & Partner
(86) International application number: PCT/CN2025/097303
(87) International publication number: WO 2026/066178

(57) **Abstract**

The present disclosure provides a command processing circuit, a command processing method, and a PIM apparatus. The command processing circuit includes: a PIM command identification module, electrically connected to a command address bus of the PIM apparatus and configured to: receive a command signal through the command address bus and determine a type of the command signal currently received; and transmit the command signal to a conventional command processing module if the command signal currently received is determined to be a DRAM conventional command; or transmit the command signal to a PIM command processing module if the command signal currently received is determined to be a PIM-related command; the PIM command processing module, electrically connected to the PIM command identification module and configured to: receive the PIM-related command, perform decoding processing on the PIM-related command, and perform a corresponding operation based on a decoding result; and the conventional command processing module, electrically connected to the PIM command identification module and configured to: receive the DRAM conventional command and perform decoding processing on the DRAM conventional command. The present disclosure is at least beneficial for avoiding mode switching and enhancing system performance.

## Description

The present application claims priority to Chinese Patent Application No. 202411359383.1 filed with China National Intellectual Property Administration on September 26, 2024, and entitled "COMMAND PROCESSING CIRCUIT, COMMAND PROCESSING METHOD, AND PIM APPARATUS", the content of which is incorporated herein by reference in its entirety.

### TECHNICAL FIELD

Embodiments of the present disclosure relate to the field of processing-in-memory (processing-in-memory, PIM), and in particular, to a command processing circuit, a command processing method, and a PIM apparatus.

### BACKGROUND

In the conventional computer structure, data is stored in the memory, and the processor is responsible for reading the data from the memory for processing and then writing the results back to the memory after the processing is completed. This method has bottlenecks in data transmission. Especially when large-scale data and complex computational tasks are processed, frequent data transmission consumes a significant amount of time and energy. To solve this problem, the concept of processing-in-memory PIM is proposed. The PIM apparatus can perform both data storage and direct arithmetic operations, thereby improving data processing speed.

### SUMMARY

Embodiments of the present disclosure provide a command processing circuit, a command processing method, and a PIM apparatus, which are at least beneficial for avoiding mode switching and enhancing system performance.

In a first aspect, the embodiments of the present disclosure provide a command processing circuit. The command processing circuit, applied to a PIM apparatus, includes:
a PIM command identification module, electrically connected to a command address bus of the PIM apparatus and configured to: receive a command signal through the command address bus and determine a type of the command signal currently received; and transmit the command signal to a conventional command processing module if the command signal currently received is determined to be a DRAM conventional command; or transmit the command signal to a PIM command processing module if the command signal currently received is determined to be a PIM-related command;
the PIM command processing module, electrically connected to the PIM command identification module and configured to: receive the PIM-related command, perform decoding processing on the PIM-related command, and perform a corresponding operation based on a decoding result; and
the conventional command processing module, electrically connected to the PIM command identification module and configured to: receive the DRAM conventional command and perform decoding processing on the DRAM conventional command.

In some embodiments, the PIM-related command includes: a PIM mode enabling command, a PIM operation command, a PIM execution command, and a no-operation command. The PIM mode enabling command is used to indicate entry into a PIM mode; the PIM operation command at least includes an addition command and a multiplication command, and the PIM operation command is registered in the PIM command processing module; the PIM execution command is used to retrieve the PIM operation command from the PIM command processing module and transmit the PIM operation command to an execution module of the PIM apparatus.

In some embodiments, the DRAM conventional command at least includes: a read command, a write command, and a refresh command.

In some embodiments, the PIM command identification module is further configured to: determine a command signal received within a preset time after receiving the PIM mode enabling command as the PIM-related command and transmit the PIM-related command to the PIM command processing module.

In some embodiments, the PIM command identification module includes:
a first identification unit, configured to: receive the command signal, determine the command signal based on a PIM command truth table, and output a first flag signal in a valid state if the command signal currently received is determined to be the PIM mode enabling command, otherwise output the first flag signal in an invalid state; or output a second flag signal in the valid state if the command signal currently received is determined to be the PIM execution command, otherwise output the second flag signal in the invalid state;
a timing unit, configured to: receive the first flag signal, clear and start timing in response to the first flag signal in the valid state, and output a third flag signal in the valid state when a timing result is less than the preset time and greater than 0, otherwise output the third flag signal in the invalid state; and
a judgment unit, configured to: receive the first flag signal, the second flag signal, and the third flag signal, determine the command signal currently received as the PIM-related command if at least one of the first flag signal, the second flag signal, and the third flag signal is in the valid state, and transmit the command signal to the PIM command processing module; otherwise determine the command signal currently received as the DRAM conventional command and transmit the command signal to the conventional command processing module.

In some embodiments, the command address bus transmits the PIM operation command within the preset time after transmitting the PIM mode enabling command.

In some embodiments, the PIM command processing module includes:
a second identification unit, configured to: receive the PIM-related command, decode and determine the PIM-related command based on a PIM command truth table, and output a PIM mode enabling command indication signal in a valid state if the PIM-related command currently received is determined to be the PIM mode enabling command, otherwise output the PIM mode enabling command indication signal in an invalid state; output a PIM operation command indication signal in the valid state if the PIM-related command currently received is determined to be the PIM operation command, otherwise output the PIM operation command indication signal in the invalid state; or output a PIM execution command indication signal in the valid state if the PIM-related command currently received is determined to be the PIM execution command, otherwise output the PIM execution command indication signal in the invalid state; and
a command register, configured to: store the PIM operation command in response to the PIM operation command indication signal in the valid state; and output the PIM operation command to the execution module of the PIM apparatus in response to the PIM execution command indication signal in the valid state.

In some embodiments, the PIM command processing module further includes:
a counter, electrically connected to the second identification unit and configured to: count the PIM operation command in response to the PIM operation command indication signal in the valid state and output a count value; and clear the count value when the PIM apparatus is powered on for a first time; and
an address decoding module, electrically connected to the second identification unit, the counter, and the command register and configured to: decode the count value and/or the PIM execution command and output an address signal, where the PIM execution command includes position information of the PIM operation command to be retrieved in the command register, and the address signal is used to indicate an address of the command register.

In some embodiments, the command register receives the address signal and stores, in response to the PIM operation command indication signal in the valid state, the PIM operation command into a corresponding address based on the address signal; or retrieves and outputs, in response to the PIM execution command indication signal in the valid state, the corresponding PIM operation command based on the address signal.

In some embodiments, the counter clears the count value in response to the PIM mode enabling command indication signal in the valid state.

In some embodiments, the address decoding module decodes the PIM execution command and outputs the address signal in response to the PIM execution command indication signal in the valid state; or decodes the count value and outputs the address signal in response to the PIM execution command indication signal in the invalid state.

In a second aspect, the embodiments of the present disclosure provide a command processing method. The command processing method, applied to a PIM apparatus, includes:
receiving a command signal through a command address bus;
determining a type of the command signal currently received, and transmitting the command signal to a conventional command processing module if the command signal currently received is determined to be a DRAM conventional command; or transmitting the command signal to a PIM command processing module if the command signal currently received is determined to be a PIM-related command; and
performing, by the PIM command processing module, decoding processing on the PIM-related command, and performing a corresponding operation based on a decoding result; or
performing, by the conventional command processing module, decoding processing on the DRAM conventional command, and performing a corresponding operation based on a decoding result.

In some embodiments, determining the type of the command signal currently received includes: determining the command signal based on a PIM command truth table; determining a PIM mode enabling command, a PIM execution command, and a command signal received within a preset time after the PIM mode enabling command all as PIM-related commands; and determining remaining commands as DRAM conventional commands.

In some embodiments, performing, by the PIM command processing module, decoding processing on the PIM-related command, and performing the corresponding operation based on the decoding result includes:
identifying the PIM-related command; and
controlling a counter to perform an operation of adding 1 if a PIM operation command is identified, decoding a count value of the counter to obtain an address signal, and storing the PIM operation command into a command register based on the address signal; or
decoding the PIM execution command to obtain an address signal if the PIM execution command is identified, and retrieving and outputting the corresponding PIM operation command from the command register based on the address signal.

In a third aspect, the embodiments of the present disclosure provide a PIM apparatus. The PIM apparatus at least includes the command processing circuit according to the first aspect.

The technical solutions according to the embodiments of the present disclosure at least have the following advantages:
By first determining the type of a command signal and then transmitting the command signal to the corresponding command processing module for the corresponding operation, it is no longer necessary to set the storage mode and the PIM mode in separate time segments or switch between modes. This enables the execution of normal DRAM read/write operations and PIM unit computations, thereby improving the operational efficiency of the PIM apparatus and enhancing system performance.

### BRIEF DESCRIPTION OF DRAWINGS

One or more embodiments are illustrated by figures in the corresponding drawings. These exemplary explanations do not constitute limitations on the embodiments, and elements with identical reference numerals in the drawings represent similar elements. Unless expressly stated otherwise, the figures in the drawings do not constitute a proportion limitation. To more clearly illustrate the technical solutions in the embodiments of the present disclosure or prior art, a brief introduction to the drawings required for the description of the embodiments is given hereinafter. It is evident that the drawings described hereinafter are merely some embodiments of the present disclosure. For those of ordinary skill in the art, other drawings may also be obtained based on these drawings without creative effort.
FIG. 1 is a schematic structural diagram of a PIM apparatus according to the embodiments of the present disclosure;
FIG. 2 is a schematic structural diagram of a command processing circuit according to the embodiments of the present disclosure;
FIG. 3 is a signal waveform diagram of a PIM command identification module according to the embodiments of the present disclosure; and
FIG. 4 is a schematic flowchart of a command processing method according to the embodiments of the present disclosure.

### DESCRIPTION OF EMBODIMENTS

The technical solutions in the embodiments of the present disclosure will be clearly and completely described hereinafter with reference to the drawings in the embodiments of the present disclosure. It can be understood that the specific embodiments described herein are merely illustrative of the related application and are not intended to limit the present application. In addition, it should be noted that for the convenience of description, only the portions relevant to the related application are illustrated in the drawings. Unless otherwise defined, all technical and scientific terms used herein have the same meaning as commonly understood by those skilled in the art to which the present disclosure belongs. The terms used herein are for the purpose of describing the embodiments of the present disclosure only and are not intended to limit the present disclosure. In the following description, reference is made to "some embodiments", which describe subsets of all possible embodiments, but it can be understood that "some embodiments" may be the same subset or different subsets of all possible embodiments, and may be combined with each other without conflict. It should be noted that the terms "first\second\third" referred to in the embodiments of the present disclosure are merely used to distinguish similar objects and do not represent a specific ordering for the objects. It can be understood that "first\second\third" may be subjected to interchange of a specific order or sequence if permitted, such that the embodiments of the present disclosure described herein can be implemented in an order other than that shown or described herein.
Dynamic Random Access Memory (Dynamic Random Access Memory, DRAM)
Synchronous Dynamic Random Access Memory (Synchronous Dynamic Random Access Memory, SDRAM)
Double Data Rate SDRAM (Double Data Rate SDRAM, DDR)
Low Power DDR (Low Power DDR, LPDDR)
Processing-In-Memory (Processing-In-Memory, PIM)
Command (Command, CMD)
Multiplication Operation (Multiplication, MUL)
Addition Operation(Addition, ADD)
Command Register (Command Register, CR)
Command Address Bus (Command Address Bus, CA Bus)

The PIM apparatus can perform both data storage and direct arithmetic operations. Data storage can be implemented in the storage mode by conventional memory arrays, such as storing data by DRAM memory arrays. Arithmetic operations can be implemented in the PIM mode by related operation units in the PIM apparatus. Because the command address bus CA Bus is shared, the PIM apparatus usually needs to be divided into a storage mode and a PIM mode during operation, operating in separate time segments. In the storage mode, the read/write command related to storage is processed, and in the PIM mode, various commands related to computation are processed. This method requires mode switching, and the mode switching process consumes significant time, reducing system performance.

Based on this, the embodiments of the present disclosure provide a command processing circuit. The command processing circuit, which is applied to a PIM apparatus, includes: a PIM command identification module, a PIM command processing module, and a conventional command processing module. The PIM command identification module is electrically connected to a command address bus of the PIM apparatus and configured to: receive a command signal through the command address bus and determine the type of the command signal currently received; and transmit the command signal to the conventional command processing module if the command signal currently received is determined to be a DRAM conventional command; or transmit the command signal to the PIM command processing module if the command signal currently received is determined to be a PIM-related command. The PIM command processing module is electrically connected to the PIM command identification module and configured to: receive the PIM-related command, perform decoding processing on the PIM-related command, and perform a corresponding operation based on a decoding result. The conventional command processing module is electrically connected to the PIM command identification module and configured to: receive the DRAM conventional command and perform decoding processing on the DRAM conventional command. As such, through the design of the command processing circuit, the PIM apparatus can execute normal DRAM read/write operations and PIM unit computations without a need to switch between modes, thereby improving the operational efficiency of the PIM apparatus and enhancing system performance.

The embodiments of the present disclosure are described in detail hereinafter with reference to the drawings.

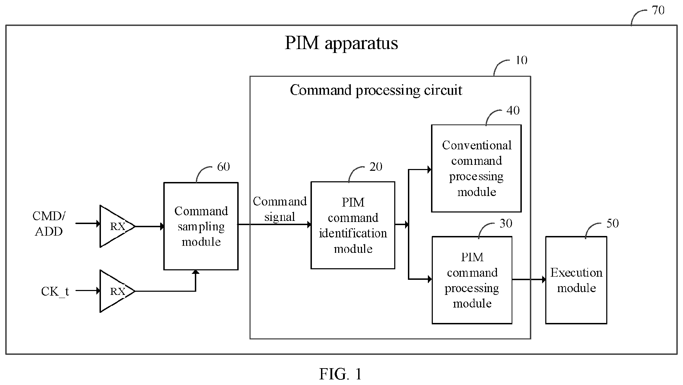

In one embodiment of the present disclosure, referring to FIG. 1, a schematic structural diagram of a PIM apparatus 70 according to the embodiments of the present disclosure is illustrated. The PIM apparatus 70 includes a command processing circuit 10. As shown in FIG. 1, the command processing circuit 10 includes:
a PIM command identification module 20, electrically connected to a command address bus of the PIM apparatus 70 and configured to: receive a command signal through the command address bus and determine the type of the command signal currently received; and transmit the command signal to a conventional command processing module 40 if the command signal currently received is determined to be a DRAM conventional command; or transmit the command signal to a PIM command processing module 30 if the command signal currently received is determined to be a PIM-related command;
the PIM command processing module 30, electrically connected to the PIM command identification module 20 and configured to: receive the PIM-related command, perform decoding processing on the PIM-related command, and perform a corresponding operation based on a decoding result; and
the conventional command processing module 40, electrically connected to the PIM command identification module 20 and configured to: receive the DRAM conventional command and perform decoding processing on the DRAM conventional command.

The PIM apparatus 70 further includes a receiver (receiver, RX) and a command sampling module 60. The receiver is configured to receive a command address signal (command/address, CMD/ADD) and a clock signal CK_t. In the command sampling module, the clock signal CK_t samples the command address signal CMD/ADD and outputs a command signal. The PIM command identification module 20 receives a command signal through the command address bus and determines the type of the command signal currently received; and transmits the command signal to the conventional command processing module 40 if the command signal is determined to be a DRAM conventional command; or transmits the command signal to the PIM command processing module 30 if the command signal is determined to be a PIM-related command. By first determining the type of the command signal, and then transmitting it to the corresponding command processing module for the corresponding operation, it is no longer necessary to set the storage mode and the PIM mode in separate time segments or switch between modes, thereby improving the operational efficiency of the PIM apparatus and enhancing system performance.

The conventional command processing module 40 receives the DRAM conventional command, performs decoding processing on the command signal based on the DRAM command truth table, determines a specific type of the DRAM conventional command, and transmits the DRAM conventional command to a corresponding functional module to execute a corresponding operation on the DRAM memory array. In some embodiments, the DRAM conventional command at least includes: a read command, a write command, and a refresh command. It can be understood that the DRAM conventional command may further include an activation command, a pre-charge command, a power saving mode, and the like.

The PIM command processing module 30 receives the PIM-related command, performs decoding processing on the PIM-related command, and performs a corresponding operation based on a decoding result. In some embodiments, the PIM-related command includes: a PIM mode enabling command, a PIM operation command, a PIM execution command, and a no-operation command. The PIM mode enabling command is used to indicate entry into a PIM mode; the PIM operation command at least includes an addition command and a multiplication command, and the PIM operation command is registered in the PIM command processing module 30; the PIM execution command is used to retrieve the PIM operation command from the PIM command processing module 30 and transmit the PIM operation command to an execution module 50 of the PIM apparatus to execute a corresponding operation.

The PIM command processing module 30 decodes the command signal based on the PIM command truth table, and determines a specific type of the PIM-related command based on the decoding result, so as to perform corresponding processing. Specifically, if the PIM operation command is received, the PIM operation command is registered in the PIM command processing module 30; if the PIM execution command is received, the PIM operation command is retrieved from the PIM command processing module 30 and transmitted to the execution module 50 of the PIM apparatus. Because the storage mode and the PIM mode are no longer set in separate time segments, and the PIM operation is no longer performed centrally, the transmission of the PIM operation command becomes more flexible. The PIM operation command can be temporarily stored first and then retrieved and executed upon receiving the PIM execution command. As such, the operation of the PIM apparatus becomes more flexible and efficient. It can be understood that in addition to the addition command and the multiplication command, the PIM operation command may further include a shift command, a complement command, and the like, which may be set based on the system requirement.

In some embodiments, the PIM command identification module 20 is further configured to determine a command signal received within a preset time after receiving the PIM mode enabling command as a PIM-related command and transmit the PIM-related command to the PIM command processing module 30. Because both the DRAM conventional command and the PIM-related command are transmitted through the common command address bus, and some PIM operation commands may overlap with DRAM conventional commands in the truth table, determining the command signal received within the preset time after the PIM mode enabling command as the PIM-related command allows for better compatibility between the PIM-related command and the DRAM conventional command.

In some embodiments, the command address bus transmits the PIM operation command within the preset time after transmitting the PIM mode enabling command. As such, even if the PIM operation command overlaps with the DRAM conventional command in the truth table, the PIM operation command may also be determined to be a PIM-related command and transmitted to the PIM command processing module 30. In other words, the truth table of the PIM operation command and the DRAM conventional command can overlap without affecting the operation of the PIM apparatus, thereby helping to save the PIM command set. It should be noted that the PIM mode enabling command and the PIM execution command should avoid overlapping with the DRAM conventional command in the truth table, to prevent misinterpretation. In this way, it can not only save the PIM command set but also enable the PIM apparatus to be compatible with both the PIM-related command and the DRAM conventional command.

It can be understood that the preset time may be designed based on the system requirement and the number of PIM operation commands that can be temporarily stored in the PIM command processing module 30. The system requirement includes the computational requirement of the GPU/CPU/SOC within a period of time. Generally, the larger the number of PIM operation commands that can be temporarily stored in the PIM command processing module 30, the longer the preset time can be set.

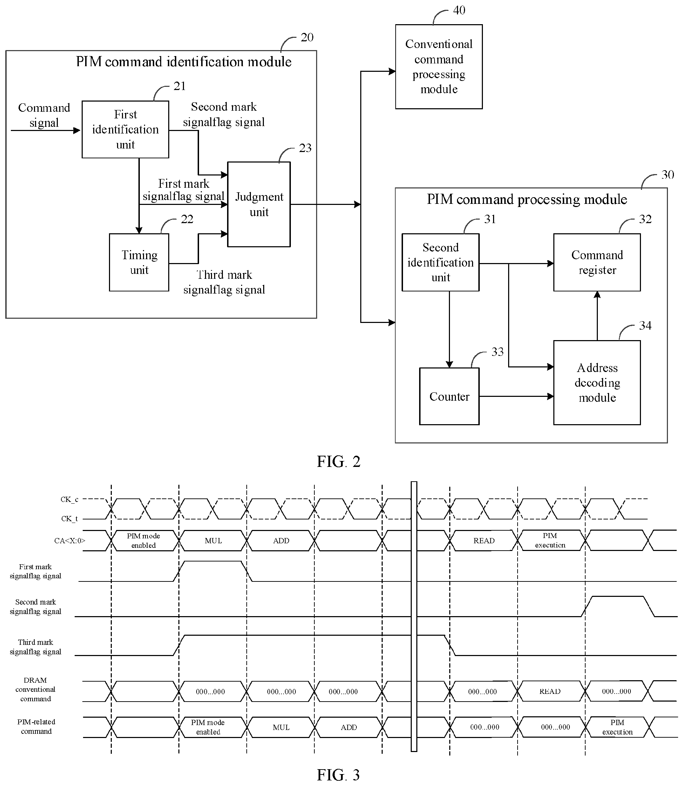

In some embodiments, as shown in FIG. 2, the PIM command identification module 20 includes:
a first identification unit 21, configured to: receive a command signal, determine the command signal based on a PIM command truth table, and output a first flag signal in a valid state if the command signal currently received is determined to be the PIM mode enabling command, otherwise output the first flag signal in an invalid state; or output a second flag signal in the valid state if the command signal currently received is determined to be the PIM execution command, otherwise output the second flag signal in the invalid state;
a timing unit 22, configured to: receive the first flag signal, clear and start timing in response to the first flag signal in the valid state, and output a third flag signal in the valid state when the timing result is less than a preset time and greater than 0, otherwise output the third flag signal in the invalid state; and
a judgment unit 23, configured to: receive the first flag signal, the second flag signal, and the third flag signal, determine the command signal currently received as the PIM-related command if at least one of the first flag signal, the second flag signal, and the third flag signal is in the valid state, and transmit the command signal to the PIM command processing module 30; otherwise determine the command signal currently received as the DRAM conventional command and transmit the command signal to the conventional command processing module 40.

The first identification unit 21 determines a specific type of the PIM-related command based on the PIM command truth table and then can identify the PIM mode enabling command and the PIM execution command and output a corresponding flag signal. The first identification unit 21 can be implemented by a decoder and some logic circuits, and the specific design needs to be based on the truth table. The timing unit 22 starts timing after identifying the PIM mode enabling command and outputs a third flag signal in a valid state when the timing result is less than the preset time and greater than 0. The purpose is to ensure that all command signals received within the preset time after receiving the PIM mode enabling command are determined to be the PIM-related command. The timing unit 22 can be implemented by a counter circuit and some logic circuits. The judgment unit 23 determines the type of the command signal based on the states of the first flag signal, the second flag signal, and the third flag signal. If at least one of the flag signals is in the valid state, the command signal is determined to be a PIM-related command; otherwise, the command signal is determined to be a DRAM conventional command. In this way, the PIM mode enabling command, the PIM execution command, and the command signal received within the preset time after the PIM mode enabling command may all be determined to be PIM-related commands. Since the command address bus transmits the PIM operation command within the preset time after transmitting the PIM mode enabling command, the PIM operation command may also be determined to be a PIM-related command and transmitted to the PIM command processing module 30. The judgment unit 23 can be implemented by a multiplexer and some logic circuits. Specifically, the judgment unit can be implemented by selecting logic circuits such as a NAND gate, a NOR gate, or an inverter based on levels of the valid state and the invalid state.

Referring to FIG. 3, a signal waveform diagram of the PIM command identification module 20 in one case is illustrated. Ck_t and CK_c represent the clock signal and complementary clock signal for sampling the command address signal CA <X:0>. MUL represents the multiplication command in the PIM operation command, and ADD represents the addition command in the PIM operation command. In this embodiment, the valid state is high level, and the invalid state is low level. When the command signal currently received is the PIM mode enabling command, in the next clock cycle, the first identification unit 21 sets the first flag signal to a high level; at the same time, the timing unit 22 starts timing and sets the third flag signal to a high level. In this case, the judgment unit 23 determines the received command signal as a PIM-related command and transmits the PIM mode enabling command to the PIM command processing module 30, while the signal received by the conventional command processing module 40 is 000...000, which cannot be decoded into any DRAM conventional command. The multiplication command MUL and the addition command ADD after the PIM mode enabling command are both within the preset time, so the third flag signal remains at a high level state. As a result, the judgment unit 23 determines the multiplication command MUL and the addition command ADD as PIM-related commands and transmits the PIM-related commands to the PIM command processing module 30, while the signal received by the conventional command processing module 40 remains 000...000. After the preset time, the timing unit 22 sets the third flag signal to a low level. In this case, the DRAM read command READ is received, and the first flag signal and the second flag signal output by the first identification unit 21 are both at a low level. As a result, in the next clock cycle, the judgment unit 23 determines the received command signal as a DRAM conventional command and transmits the DRAM conventional command to the conventional command processing module 40. The signal received by the PIM command processing module 30 is 000... 000, which cannot be decoded into any PIM-related command. When the command signal currently received is the PIM execution command, in the next clock cycle, the first identification unit 21 sets the second flag signal to a high level, and the judgment unit 23 determines the received command signal as a PIM-related command and transmits the PIM execution command to the PIM command processing module 30, while the signal received by the conventional command processing module 40 is 000...000, which cannot be decoded into any DRAM conventional command. Since both the reception and transmission of the command address signal require sampling by a clock and a flip-flop, the generation of the flag signal and the determination of the command type are often delayed by one clock cycle compared to the reception time. In some cases, the delay may be two to three clock cycles. Generally, the design is carried out based on the performance requirements of the circuit and the actual circumstances.

In some embodiments, as shown in FIG. 2, the PIM command processing module 30 includes:
a second identification unit 31, configured to: receive the PIM-related command, decode and determine the PIM-related command based on a PIM command truth table, and output a PIM mode enabling command indication signal in a valid state if the PIM-related command currently received is determined to be the PIM mode enabling command, otherwise output the PIM mode enabling command indication signal in an invalid state; output a PIM operation command indication signal in the valid state if the PIM-related command currently received is determined to be the PIM operation command, otherwise output the PIM operation command indication signal in the invalid state; or output a PIM execution command indication signal in the valid state if the PIM-related command currently received is determined to be the PIM execution command, otherwise output the PIM execution command indication signal in the invalid state; and
a command register 32, configured to: store the PIM operation command in response to the PIM operation command indication signal in the valid state; and output the PIM operation command to the execution module 50 of the PIM apparatus 70 in response to the PIM execution command indication signal in the valid state.

The second identification unit 31 determines a specific type of the PIM-related command based on the PIM command truth table, and can identify the PIM mode enabling command, the PIM operation command, and the PIM execution command and output a corresponding indication signal. The second identification unit 31 can be implemented by a decoder and some logic circuits, and the specific design needs to be based on the truth table. The command register 32 can store the PIM operation command and retrieve the corresponding PIM operation command in response to the PIM execution command. Because the storage mode and the PIM mode are no longer set in separate time segments, and the PIM operation is no longer performed centrally, the transmission of the PIM operation command becomes more flexible. The PIM operation command can be temporarily stored first and then retrieved and executed upon receiving the PIM execution command. As such, the operation of the PIM apparatus becomes more flexible and efficient without a need to switch between modes, thereby enhancing system performance.

In some embodiments, as shown in FIG. 2, the PIM command processing module 30 further includes:
a counter 33, electrically connected to the second identification unit 31 and configured to: count the PIM operation command in response to the PIM operation command indication signal in the valid state, and output a count value; and clear the count value when the PIM apparatus 70 is powered on for the first time; and
an address decoding module 34, electrically connected to the second identification unit 31, the counter 33, and the command register 32 and configured to: decode the count value and/or the PIM execution command and output an address signal, where the PIM execution command includes position information of the PIM operation command to be retrieved in the command register 32, and the address signal is used to indicate an address of the command register 32.

The counter 33 counts the PIM operation command in order to provide an address at which the PIM operation command is stored in the command register 32. The address decoding module 34 decodes the count value into an address signal required by the command register 32. For example, after the PIM apparatus 70 is powered on for the first time and receives the first PIM operation command, the count value is 1, represented in binary as 001; after being decoded by the address decoding module 34, the address signal 000...0001 is obtained, and thus the first PIM operation command is stored at the position 000...0001 in the command register 32. When the second PIM operation command is received, the count value becomes 2, represented in binary as 010; after being decoded by the address decoding module 34, the address signal 000...0010 is obtained, and thus the second PIM operation command is stored at the position 000...0010 in the command register 32. When the third PIM operation command is received, the count value becomes 3, represented in binary as 011; after being decoded by the address decoding module 34, the address signal 000...0100 is obtained, and thus the third PIM operation command is stored at the position 000...0100 in the command register 32. When the fourth PIM operation command is received, the count value becomes 4, represented in binary as 100; after being decoded by the address decoding module 34, the address signal 000...1000 is obtained, and thus the fourth PIM operation command is stored at the position 000...1000 in the command register 32; and so on.

The address decoding module 34 may further decode the PIM execution command. The PIM execution command includes the position information of the PIM operation command to be retrieved in the command register 32. For example, if the PIM execution command retrieves the aforementioned third PIM operation command, then the PIM execution command is 011. After being decoded by the address decoding module 34, the address signal 000...0100 is obtained, and the PIM operation command stored at that position is retrieved. It can be understood that the address decoding module 34 can be implemented by a decoder and some logic circuits based on an address format of the command register 32.

In some embodiments, the command register 32 receives the address signal, and stores the PIM operation command into a corresponding address based on the address signal in response to the PIM operation command indication signal in the valid state; or retrieves and outputs the corresponding PIM operation command based on the address signal in response to the PIM execution command indication signal in the valid state.

When the PIM operation command indication signal in the valid state is received, the command register 32 stores the currently received PIM operation command into a corresponding position based on the address signal output by the address decoding module 34 at this time. When the PIM execution command indication signal in the valid state is received, the command register 32 retrieves a corresponding PIM operation command based on the address signal output by the address decoding module 34 at this time and outputs the PIM operation command to the execution module 50 of the PIM apparatus 70 to execute a corresponding operation. It can be understood that the command register 32 needs to rely on various indication signals and address signals to correctly store and output the PIM operation command, thereby preventing errors during operation.

In some embodiments, the counter 33 clears the count value in response to the PIM mode enabling command indication signal in the valid state. The counter 33 clears the count value when the PIM apparatus 70 is powered on for the first time. If the capacity of the command register 32 is sufficiently large, the count value may not need to be cleared during the subsequent operation of the PIM apparatus 70, allowing the count value to accumulate continuously. All PIM operation commands are stored in the command register 32. To save the capacity of the command register 32, the count value may be cleared and restarted each time a PIM mode enabling command is received. This means that the PIM operation command received after each PIM mode enabling command will overwrite the PIM operation command stored in the command register 32 from the previous PIM mode enabling command. It should be noted that the PIM execution command after the PIM mode enabling command can only retrieve the PIM operation command stored in the command register 32. In some cases, the count value may also be cleared after several PIM mode enabling commands. For example, the counter 33 may clear the count value once for every M PIM mode enabling command indication signals in the valid state the counter receives, where M is an integer greater than 0 and may be selected based on actual requirements and the capacity of the command register.

In some embodiments, the address decoding module 34 decodes the PIM execution command and outputs the address signal in response to the PIM execution command indication signal in the valid state; and decodes the count value and outputs the address signal in response to the PIM execution command indication signal in the invalid state. The address decoding module 34 may further include a multiplexer. A control terminal of the multiplexer receives the PIM execution command indication signal, and two input terminals respectively receive the PIM execution command and the count value. If the PIM execution command indication signal is in the valid state, the PIM execution command is output for decoding; if the PIM execution command indication signal is in the invalid state, the count value is output for decoding. With this setup, the PIM execution command and the count value can share one set of decoding circuits, such that circuit components of the address decoding module 34 can be saved.

It can be seen from the above analysis that the PIM command identification module 20 determines the type of the command signal currently received, and transmits the command signal to the conventional command processing module 40 if the command signal is determined to be a DRAM conventional command; or transmits the command signal to the PIM command processing module 30 if the command signal is determined to be a PIM-related command. The PIM command processing module 30 further identifies the PIM-related command. If a PIM operation command is identified, the counter 33 performs the operation of adding 1, and the address decoding module 34 decodes the count value of the counter 33 to obtain an address signal and stores the PIM operation command into the command register 32 based on the address signal. If a PIM execution command is identified, the address decoding module 34 decodes the PIM execution command to obtain the address signal, retrieves and outputs the corresponding PIM operation command from the command register 32 based on the address signal, and transmits the PIM operation command to the execution module 50 of the PIM apparatus 70.

In summary, the command processing circuit according to the embodiments of the present disclosure first determines the type of a command signal and then transmits the command signal to the corresponding command processing module for the corresponding operation. As such, it is no longer necessary to set the storage mode and the PIM mode in separate time segments or switch between modes. This enables the execution of normal DRAM read/write operations and PIM unit computations, thereby improving the operational efficiency of the PIM apparatus and enhancing system performance.

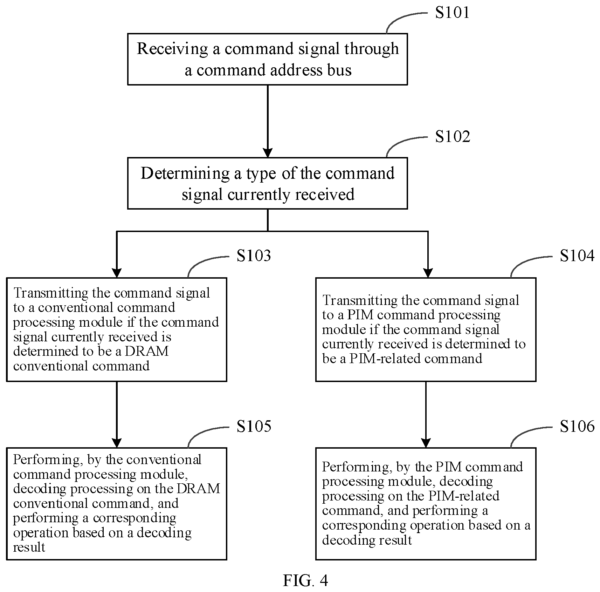

In yet another embodiment of the present disclosure, referring to FIG. 4, a schematic flowchart of a command processing method according to the embodiments of the present disclosure is illustrated. As shown in FIG. 4, the method is applied to a PIM apparatus. The method includes:
S101, receiving a command signal through a command address bus;
S102, determining a type of the command signal currently received;
S103, transmitting the command signal to a conventional command processing module if the command signal currently received is determined to be a DRAM conventional command, and performing step S105;
S104, transmitting the command signal to a PIM command processing module if the command signal currently received is determined to be a PIM-related command, and performing step S106;
S105, performing, by the conventional command processing module, decoding processing on the DRAM conventional command, and performing a corresponding operation based on a decoding result; and
S106, performing, by the PIM command processing module, decoding processing on the PIM-related command, and performing a corresponding operation based on a decoding result.

The command processing method involves first determining the type of a command signal and then transmitting the command signal to the corresponding command processing module for the corresponding operation. As such, it is no longer necessary to set the storage mode and the PIM mode in separate time segments or switch between modes. This enables the execution of normal DRAM read/write operations and PIM unit computations, thereby improving the operational efficiency of the PIM apparatus and enhancing system performance.

In some embodiments, determining the type of the command signal currently received includes: determining the command signal based on a PIM command truth table; determining a PIM mode enabling command, a PIM execution command, and a command signal received within a preset time after the PIM mode enabling command all as PIM-related commands; and determining the remaining commands as DRAM conventional commands. In some embodiments, the command address bus transmits the PIM operation command within the preset time after transmitting the PIM mode enabling command. As such, even if the PIM operation command overlaps with the DRAM conventional command in the truth table, the PIM operation command may also be determined to be a PIM-related command and transmitted to the PIM command processing module 30. The PIM mode enabling command is used to indicate entry into a PIM mode; the PIM operation command at least includes an addition command and a multiplication command, and the PIM operation command is registered in the PIM command processing module; the PIM execution command is used to retrieve the PIM operation command from the PIM command processing module and transmit the PIM operation command to an execution module of the PIM apparatus to execute a corresponding operation.

In some embodiments, performing, by the PIM command processing module, decoding processing on the PIM-related command, and performing the corresponding operation based on the decoding result includes: identifying the PIM-related command; controlling a counter to perform the operation of adding 1 if a PIM operation command is identified, decoding a count value of the counter to obtain an address signal, and storing the PIM operation command into a command register based on the address signal; or decoding the PIM execution command to obtain an address signal if the PIM execution command is identified, and retrieving and outputting the corresponding PIM operation command from the command register based on the address signal. Because the storage mode and the PIM mode are no longer set in separate time segments, and the PIM operation is no longer performed centrally, the transmission of the PIM operation command becomes more flexible. The PIM operation command can be temporarily stored first and then retrieved and executed upon receiving the PIM execution command. As such, the operation of the PIM apparatus becomes more flexible and efficient without a need to switch between modes, thereby enhancing system performance.

In yet another embodiment of the present disclosure, referring to FIG. 1, a schematic diagram of a composition structure of a PIM apparatus 70 according to the embodiments of the present disclosure is illustrated. As shown in FIG. 1, the PIM apparatus 70 at least includes the aforementioned command processing circuit 10.

As shown in FIG. 1, the PIM apparatus 70 further includes a receiver (receiver, RX), a command sampling module 60, and an execution module 50. The receiver is configured to receive a command address signal (command/address, CMD/ADD) and a clock signal CK_t. In the command sampling module, the clock signal CK_t samples the command address signal CMD/ADD and outputs a command signal. The execution module 50 can execute a PIM-related operation. The PIM apparatus 70 further includes a memory array, which is not illustrated in the figure.

The command processing circuit 10 included in the PIM apparatus first determines the type of a command signal and then transmits the command signal to the corresponding command processing module for the corresponding operation. As such, it is no longer necessary to set the storage mode and the PIM mode in separate time segments or switch between modes. This enables the execution of normal DRAM read/write operations and PIM unit computations, thereby improving the operational efficiency of the PIM apparatus and enhancing system performance.

The foregoing description shows merely preferred embodiments of the present disclosure and is not intended to limit the protection scope of the present disclosure. It should be noted that in the present disclosure, the terms "include", "comprise", or any other variants thereof are intended to cover non-exclusive inclusion, such that a process, a method, an item, or an apparatus including a series of elements includes not only those elements but also other elements not explicitly listed, or elements inherent to such process, method, item, or apparatus. Without further limitation, an element defined by the phrase "including a..." does not exclude the presence of additional identical elements in the process, method, item, or apparatus that includes the element. The serial numbers of the embodiments of the present disclosure described above are for the purpose of describing only and do not represent the superiority or inferiority of the embodiments. The methods disclosed in the method embodiments provided in the present disclosure may be combined in any manner without conflict to obtain new method embodiments. The features disclosed in the product embodiments provided in the present disclosure may be combined in any manner without conflict to obtain new product embodiments. The features disclosed in the method or device embodiments provided in the present disclosure may be combined in any manner without conflict to obtain new method or device embodiments. The foregoing description is merely the specific embodiments of the present disclosure, but the protection scope of the present disclosure is not limited thereto. Any variations or substitutions that can be readily conceived by a person skilled in the art within the technical scope disclosed by the present disclosure shall all fall within the protection scope of the present disclosure. Therefore, the protection scope of the present disclosure shall be defined by the protection scope of the claims.

## Claims

1. A command processing circuit, applied to a processing-in-memory (PIM) apparatus, comprising:
a PIM command identification module (20), electrically connected to a command address bus of the PIM apparatus and configured to: receive a command signal through the command address bus and determine a type of the command signal currently received; and transmit the command signal to a conventional command processing module (40) if the command signal currently received is determined to be a dynamic random access memory (DRAM) conventional command; or transmit the command signal to a PIM command processing module (30) if the command signal currently received is determined to be a PIM-related command;
the PIM command processing module (30), electrically connected to the PIM command identification module and configured to: receive the PIM-related command, perform decoding processing on the PIM-related command, and perform a corresponding operation based on a decoding result; and
the conventional command processing module (40), electrically connected to the PIM command identification module and configured to: receive the DRAM conventional command and perform decoding processing on the DRAM conventional command.

2. The command processing circuit according to claim 1, wherein the PIM-related command comprises: a PIM mode enabling command, a PIM operation command, a PIM execution command, and a no-operation command, wherein the PIM mode enabling command is used to indicate entry into a PIM mode; the PIM operation command at least comprises an addition command and a multiplication command, and the PIM operation command is registered in the PIM command processing module; and the PIM execution command is used to retrieve the PIM operation command from the PIM command processing module and transmit the PIM operation command to an execution module of the PIM apparatus.

3. The command processing circuit according to claim 1, wherein the DRAM conventional command at least comprises: a read command, a write command, and a refresh command.

4. The command processing circuit according to claim 2, wherein the PIM command identification module is further configured to: determine a command signal received within a preset time after receiving the PIM mode enabling command as the PIM-related command and transmit the PIM-related command to the PIM command processing module.

5. The command processing circuit according to claim 4, wherein the PIM command identification module comprises:
a first identification unit (21), configured to: receive the command signal, determine the command signal based on a PIM command truth table, and output a first flag signal in a valid state if the command signal currently received is determined to be the PIM mode enabling command, otherwise output the first flag signal in an invalid state; or output a second flag signal in the valid state if the command signal currently received is determined to be the PIM execution command, otherwise output the second flag signal in the invalid state;
a timing unit (22), configured to: receive the first flag signal, clear and start timing in response to the first flag signal in the valid state, and output a third flag signal in the valid state when a timing result is less than the preset time and greater than 0, otherwise output the third flag signal in the invalid state; and
a judgment unit (23), configured to: receive the first flag signal, the second flag signal, and the third flag signal, determine the command signal currently received as the PIM-related command if at least one of the first flag signal, the second flag signal, and the third flag signal is in the valid state, and transmit the command signal to the PIM command processing module; otherwise determine the command signal currently received as the DRAM conventional command and transmit the command signal to the conventional command processing module.

6. The command processing circuit according to claim 4, wherein the command address bus transmits the PIM operation command within the preset time after transmitting the PIM mode enabling command.

7. The command processing circuit according to claim 2, wherein the PIM command processing module comprises:
a second identification unit (31), configured to: receive the PIM-related command, decode and determine the PIM-related command based on a PIM command truth table, and output a PIM mode enabling command indication signal in a valid state if the PIM-related command currently received is determined to be the PIM mode enabling command, otherwise output the PIM mode enabling command indication signal in an invalid state; output a PIM operation command indication signal in the valid state if the PIM-related command currently received is determined to be the PIM operation command, otherwise output the PIM operation command indication signal in the invalid state; or output a PIM execution command indication signal in the valid state if the PIM-related command currently received is determined to be the PIM execution command, otherwise output the PIM execution command indication signal in the invalid state; and
a command register (32), configured to: store the PIM operation command in response to the PIM operation command indication signal in the valid state; and output the PIM operation command to the execution module of the PIM apparatus in response to the PIM execution command indication signal in the valid state.

8. The command processing circuit according to claim 7, wherein the PIM command processing module further comprises:
a counter (33), electrically connected to the second identification unit and configured to: count the PIM operation command in response to the PIM operation command indication signal in the valid state and output a count value; and clear the count value when the PIM apparatus is powered on for a first time; and
an address decoding module (34), electrically connected to the second identification unit, the counter, and the command register and configured to: decode the count value and/or the PIM execution command and output an address signal, wherein the PIM execution command comprises position information of the PIM operation command to be retrieved in the command register, and the address signal is used to indicate an address of the command register.

9. The command processing circuit according to claim 8, wherein the command register receives the address signal and stores, in response to the PIM operation command indication signal in the valid state, the PIM operation command into a corresponding address based on the address signal; or retrieves and outputs, in response to the PIM execution command indication signal in the valid state, the corresponding PIM operation command based on the address signal.

10. The command processing circuit according to claim 8, wherein the counter clears the count value in response to the PIM mode enabling command indication signal in the valid state.

11. The command processing circuit according to claim 8, wherein the address decoding module decodes the PIM execution command and outputs the address signal in response to the PIM execution command indication signal in the valid state; or decodes the count value and outputs the address signal in response to the PIM execution command indication signal in the invalid state.

12. A command processing method, applied to a processing-in-memory (PIM) apparatus, comprising:
receiving a command signal through a command address bus;
determining a type of the command signal currently received, and transmitting the command signal to a conventional command processing module if the command signal currently received is determined to be a dynamic random access memory (DRAM) conventional command; or transmitting the command signal to a PIM command processing module if the command signal currently received is determined to be a PIM-related command; and
performing, by the PIM command processing module, decoding processing on the PIM-related command, and performing a corresponding operation based on a decoding result; or
performing, by the conventional command processing module, decoding processing on the DRAM conventional command, and performing a corresponding operation based on a decoding result.

13. The command processing method according to claim 12, wherein determining the type of the command signal currently received comprises: determining the command signal based on a PIM command truth table; determining a PIM mode enabling command, a PIM execution command, and a command signal received within a preset time after the PIM mode enabling command all as PIM-related commands; and determining remaining commands as DRAM conventional commands.

14. The command processing method according to claim 13, wherein performing, by the PIM command processing module, decoding processing on the PIM-related command, and performing the corresponding operation based on the decoding result comprises:
identifying the PIM-related command; and
controlling a counter to perform an operation of adding 1 if a PIM operation command is identified, decoding a count value of the counter to obtain an address signal, and storing the PIM operation command into a command register based on the address signal; or
decoding the PIM execution command to obtain an address signal if the PIM execution command is identified, and retrieving and outputting the corresponding PIM operation command from the command register based on the address signal.

15. A processing-in-memory (PIM) apparatus, comprising the command processing circuit according to any one of claims 1 to 11.
